# NEUE EUROPÄISCHE PATENTSCHRIFT

(11) **EP 1 733 418 B2**
(45) Veröffentlichungstag und Bekanntmachung des Hinweises auf die Entscheidung über den Einspruch: **17.01.2018**
(45) Hinweis auf die Patenterteilung: 08.09.2010
(21) Anmeldenummer: 04722226.0
(22) Anmeldetag: 22.03.2004
(51) Int. Cl.: H01L 21/00, H01L 21/306

(54) **VERFAHREN ZUR ELEKTRISCHEN ISOLATION BEIDER SEITEN VON SILIZIUMSCHEIBEN DURCH DEREN EINSEITIGE NASSCHEMISCHE BEHANDLUNG UNTER VERWENDUNG EINES FLÜSSIGKEITSBADES**
PROCESS FOR ELECTRICALLY ISOLATING BOTH SIDES OF SILICON WAFERS BY THEIR SINGLE-SIDED WET-CHEMICAL TREATMENT USING A LIQUID BATH
PROCÉDÉ D'ISOLATION ÉLECTRIQUE DES DEUX CÔTÉS DE PLAQUES DE SILICIUM PAR UN TRAITEMENT CHIMIQUE UNILATÉRAL UTILISANT UN BAIN DE LIQUIDE

(43) Veröffentlichungstag der Anmeldung: 20.12.2006
(73) Patentinhaber: RENA Technologies GmbH, 78148 Gütenbach (DE)
(72) Erfinder: DELAHAYE, Franck, 79279 Vörstetten (DE)
(74) Vertreter: Heyerhoff Geiger & Partner Patentanwälte PartGmbB
(86) Internationale Anmeldenummer: PCT/DE2004/000597
(87) Internationale Veröffentlichungsnummer: WO 2005/093788

(56) Entgegenhaltungen:
- EP-A- 0 496 899
- EP-A- 1 073 095
- EP-A- 1 184 091
- WO-A-99/17344
- DE-A- 3 811 068
- US-A- 4 004 045
- US-A- 5 270 079
- US-A- 5 601 655
- US-A- 5 660 642
- US-B1- 6 412 500

## Beschreibung

Die vorliegende Erfindung betrifft allgemein die Behandlung bzw. Bearbeitung von Substratoberflächen. Insbesondere betrifft die Erfindung Verfahren zur Modifikation der Oberfläche von Siliziumscheiben.

Bei der Herstellung von Siliziumscheiben, Siliziumplatten oder Wafern für die Halbleiter- und Solarzellenindustrie werden die Wafer einer Reihe von mechanischen und/oder chemischen Behandlungsschritten unterzogen, damit sie die gewünschten Größen und Produkteigenschaften erhalten. Im folgenden werden die nach dem Stand der Technik üblichen Prozessschritte zur Herstellung von Solarzellen beschrieben.

Zuerst wird ein Siliziumblock mit einer Drahtsäge in Scheiben geschnitten, auch Wafer genannt. Nach dem Zuschneiden werden die Wafer zum Entfernen von einer so genannten Sägeslurry gereinigt. Danach erfolgt zumeist ein nasschemisches Sägeschadenätzen unter Verwendung geeigneter Chemikalien wie insbesondere Laugen, um die durch den Schneideprozess bedingte defektreiche Schicht zu entfernen. Anschließend werden die Wafer gewaschen und getrocknet.

Bei den Wafern bzw. Substraten handelt es sich in der Regel um mit Bor p-dotierte mono- oder polykristalline Siliziumscheiben. Zur Herstellung eines für die Funktion der Solarzelle notwendigen p-n Übergangs, wird eine Seite der Siliziumscheiben n-dotiert. Diese n-Dotierung wird üblicherweise mittels Phosphordotierung ausgeführt. Hierbei wird die Substrat- bzw. Siliziumoberfläche durch Einlagerung von Phosphoratomen modifiziert, wobei als Phosphorquelle in der Regel ein Gas oder eine flüssig-pastöse Zusammensetzung eingesetzt wird. Nach entsprechender Inkubation bzw. Beschichtung der Siliziumscheiben in dem Gas bzw. mit der Zusammensetzung erfolgt die Diffusion bzw. An- oder Einlagerung der Phosphoratome in die Siliziumoberfläche durch Erhitzen auf gewöhnlich 800 bis 1000°C. Nach dieser Phosphordotierung weist die Siliziumplatte eine bis wenige µm dicke, mit Phosphor n+-dotierte Schicht auf.

Ein Problem bei dieser Oberflächenmodifikation besteht darin, dass zumeist nicht nur die gewünschte Oberfläche (Oberseite) sondern auch die gegenüberliegende Oberfläche (Unterseite) sowie insbesondere die umlaufenden Kanten der Substratscheiben durch die Behandlung modifiziert bzw. dotiert werden, woraus in der späteren Anwendung die Gefahr von Kurzschlüssen resultiert, da die Kanten elektrisch leitfähig sind. Eine zusätzliche Dotierung der Unterseite, wie sie z.B. durch Gasphasendotierung erfolgt, ist jedoch in vielen Anwendungsgebieten hinnehmbar, da die n+ Dotierung der Unter- bzw. Rückseiten der Platten anschließend zumeist durch Bildung eines "Aluminium Back Surface Field" in eine p+ Dotierung überführt wird, die z.B. für die spätere Kontaktierung einer Solarzelle notwendig ist. Derart behandelte Wafer besitzen jedoch immer Kanten, die Phosphoratome aufweisen und somit elektrisch leitfähig sind, was ohne weitere Behandlung zu Siliziumscheiben mit dem oben erwähnten Nachteil eines Risikos zur Entstehung von Kurzschlüssen in der späteren Anwendung führt.

Um dieses Problem zu beseitigen, sind im Stand der Technik unterschiedliche Verfahren entwickelt worden. Beispielsweise wird das Problem der elektrisch leitfähigen Kanten gelöst, indem diese mechanisch abgeschliffen werden. Durch das Schleifen können jedoch wie beim Sägen Defekte in der Kristallstruktur entstehen, welche zu elektrischen Verlusten führen. Der größte Nachteil dieser Vorgehensweise besteht aber in der erheblichen Bruchgefahr für die empfindlichen Scheiben.

Darüber hinaus wird vorgeschlagen, die auf der Unter- bzw. Rückseite vorhandene leitfähige Schicht im äußeren Bereich bzw. am Rand durch Einwirkung eines Laserstrahles zu unterbrechen. Diese Kantenisolierung mittels Laser ist jedoch noch nicht etabliert und wirft insbesondere bei der Automatisierung des Prozesses sowie hinsichtlich des erreichbaren Durchsatzes Probleme auf. Weiterhin besteht die Gefahr, dass nachfolgende Verfahrensschritte sowie der Wirkungsgrad z.B. einer entsprechend hergestellten Zelle beeinträchtigt werden können durch Ablagerung von beim Lasern entstehenden Verbrennungsprodukten auf der Waferoberfläche.

Schließlich wird vorgeschlagen, mehrere Platten zu stapeln und die Kanten des Plattenstapels mittels Plasma zu ätzen. Das Kantenisolieren mittels Plasma erfordert, dass die Wafer aufeinander gestapelt werden. Sowohl die Stapelung als auch die Handhabung der Stapel erfolgen entweder manuell oder aber mit sehr hohem apparativen Aufwand automatisiert. Die Prozessierung in Stapeln verursacht daher immer eine Unterbrechung oder Umstellung des Produktionsflusses, und zwar sowohl im Rahmen einer Fertigung nach dem "Batch"-Prinzip, bei dem die Wafer in Prozesscarriern transportiert werden, als auch bei einer "Inline"-Fertigung, bei der die Wafer auf Transportbändern oder Rollen etc. durch die unterschiedlichen Verfahrensschritte geführt werden. Ferner sind die Wafer aufgrund der aufwendigen Handhabung wieder einer erhöhten Bruchgefahr ausgesetzt.

Ein anderes Verfahren, bei dem nur die Kanten behandelt werden, wird in der DE 100 32 279 A1 vorgeschlagen. Die DE 100 32 279 A1 beschreibt ein Verfahren zur chemischen Passivierung von Randdefekten bei Silizium-Solarzellen durch ein Herausätzen der Randdefekte. Hierzu wird auf die Kanten der Silizium-Solarzellen unter Verwendung eines mit Ätzmittel getränkten Filztuchs ein Ätzmittel aufgetragen.

Weitere aus dem Stand der Technik bekannte Verfahren lösen das Problem der elektrisch leitfähigen Kanten durch ein Entfernen der leitfähigen Schicht auf den Kanten und einer Seite der Substrate mittels Ätzen in einem Säurebad. Beispielsweise beschreiben DE 43 24 647 A1 und US 2001/0029978 A1 ein mehrstufiges Ätzverfahren, bei dem ein Substrat vollständig in ein Säurebad eingetaucht wird. Damit hierbei jeweils nur ein Ätzen auf der Rückseite und den Kanten des Substrats erfolgt, muss die Vorderseite des Substrats durch einen säurebeständigen Fotoresist oder eine Maske geschützt werden.

Insbesondere ist das Ätzverfahren gemäß der DE 43 24 647 A1 undderUS 2001/0029978 A1 nicht nur zeitaufwendig, da spezielle Arbeitsschritte zum Aufbringen und Entfernen von Schutzschichten erforderlich sind, sondern erfordert auch den Einsatz zusätzlicher Materialien. Insbesondere besteht durch das Aufbringen und. Ablösen von Schutzschichten das Risiko der Beeinträchtigung der zu behandelnden Substrate. Falls eine aufgebrachte Schutzschicht fehlerhaft oder beschädigt ist, besteht das Risiko, dass die Vorderseiten der Substrate beim Ätzen beschädigt und die Substrate somit unbrauchbar werden.

Die US 5,660,642 beschreibt eine Vorrichtung und ein Verfahren zur flüssigen Behandlung und anschließenden Trocknung flacher Substrate unter Ausnutzung des Marangoni-Effekts. Die Vorrichtung umfasst zwei Behälter mit Behandlung- bzw. Spülflüssigkeit. Diese Vorrichtung wird in einem ersten Schritt in unmittelbare Nähe zur zu behandelnden Substratoberfläche gebracht, so dass beide Flüssigkeiten die Oberfläche unter Ausbildung eines Meniskus benetzen. Anschließend wird die Vorrichtung relativ zur Substratoberfläche derart "translatiert", dass ein Bereich des Substrates zuerst mit der Behandlungsflüssigkeit und dann mit der Spülflüssigkeit kontaktiert wird, bevor das Substrat in einem zusätzlichen Schritt unter Ausnutzung des Marangoni-Effekts mit einer bestimmten Geschwindigkeit bewegt und dabei getrocknet wird.

In der WO 99/17344 werden eine Vorrichtung und ein Verfahren zur nasschemischen Behandlung flacher Substrate offenbart, wobei ein jeweiliges Substrat während der Behandlung von einem darüber angeordneten Träger 16 gehalten wird und vertikal nach unten bzw. nach oben verfahren werden kann.

Die Aufgabe der vorliegenden Erfindung besteht daher darin, ein Verfahren zur einseitigen Behandlung von Siliziumscheiben bereitzustellen, bei dem auf die Verfahrensschritte des Standes der Technik im Zusammenhang mit dem Schützen bzw. Maskieren der nicht zu behandelnden Vorder- oder Oberseiten verzichtet werden kann und wobei das Verfahren in einer Fertigungs-strasse durchgeführt wird.

Die Aufgabe wird erfindungsgemäß gelöst durch Bereitstellung des Verfahrens gemäß Anspruch 1. Vorteilhafte Ausführungsformen des erfindungsgemäßen Verfahrens sind Gegenstand der Unteransprüche und/oder werden in der nachfolgenden Beschreibung dargelegt.

Erfindungsgemäß hat sich gezeigt, dass nur eine der beiden Oberflächen eines Substrats selektiv behandelt werden kann. Eine derartige einseitige Behandlung umfasst beispielsweise ein Ätzen, einer der beiden Oberflächen. Gemäß einer Ausführungsform kann z.B. nur die Ober- bzw. Unterseite eines entsprechenden Substrates wie einer Siliziumscheibe durch Ätzen modifiziert werden, wodurch das Problem der Kurzschlussbildung auf einfache Weise beseitigt wird. Zum besseren Verständnis wird im Folgenden Bezug auf ein Ätzen einer Oberfläche als Beispiel für eine einseitige Behandlung eines Substrats genommen.

Nach einer besonders bevorzugten Ausführungsform wird das erfindungsgemäße Verfahren im Rahmen einer kontinuierlichen Prozessierung durchgeführt, wobei Unterseiten der Substrate wie insbesondere Siliziumscheiben (gewünschtenfalls einschließlich der umlaufenden Kanten) mit einer in einem Flüssigkeitsbad befindlichen Ätzflüssigkeit benetzt werden.

Es wird darauf hingewiesen, dass das erfindungsgemäße Verfahren dann geeignet ist, wenn nur eine einseitige Behandlung eines Substrats gewünscht bzw. erforderlich ist. Gemäß einer bevorzugten Ausführungsform sieht das erfindungsgemäße Verfahren vor, dass das Substrat, vorzugsweise in Form einer Siliziumscheibe, nach der Phosphordotierung einer einseitigen Ätzung zur Entfernung der mit Phosphor dotierten Schicht zugeführt wird. Dies geschieht dadurch, dass nur eine Seite der Siliziumscheibe vollständig oder teilweise bzw. partiell mit einer flüssigen Zusammensetzung, die vorzugsweise NaOH, KOH, HF, HNO₃, HF mit O₃, und/oder HF mit Oxidationsmittel wie z.B. oxidierender Säure enthält, in Kontakt gebracht wird.

Dazu wird die Siliziumscheibe im wesentlichen horizontal ausgerichtet, und die zu ätzende Seite wird mit einer Ätzflüssigkeit benetzt, die sich in einem Flüssigkeitsbad befindet. Dabei wird der Abstand der Ätzflüssigkeit zur Unterseite der Siliziumscheibe so gewählt, dass die zu ätzende Seite des Substrates (gewünschtenfalls einschließlich der umlaufenden Kanten) benetzt wird, nicht aber die gegenüber liegende Seite.

Es wird darauf hingewiesen, dass dieser Ätzschritt vorzugsweise direkt nach der Phosphordotierung vorgenommen wird, da das Phosphorglasätzen zumeist nasschemisch erfolgt und die erfindungsgemäße Kantenisolation dann platzsparend und kostengünstig in der gleichen Anlage durchgeführt werden kann. Für den Fachmann ist jedoch klar, dass der erfindungsgemäße Schritt auch zu einem anderen Zeitpunkt durchgeführt werden kann. Wichtig ist allein, dass die erfindungsgemäße Ätzung vor dem Aufbringen der metallischen Kontakte auf die Rück- bzw. Unterseite eines gegebenen Substrats erfolgt.

Nach einer bevorzugten Ausführungsform des erfindungsgemäßen Verfahrens können sowohl eine Substratseite als auch die umlaufenden Kanten der Substrate in der vorliegend geschilderten Weise behandelt werden.

Nach einer nicht erfindungsgemäßen Ausführungsform werden die Substrate in ein Flüssigkeitsbad mit einer flüssigen Zusammensetzung abgesenkt, wobei das Maß des Absenkens vom Fachmann in Abhängigkeit der Dicke, des Gewichts und der Oberflächeneigenschaften des Substrats sowie der Oberflächenspannung der flüssigen Zusammensetzung leicht eingestellt werden kann. Durch exaktes Einstellen, z.B. des Füllstandes im Behandlungsbad, ist es zudem möglich, dass nicht nur die Unterseite, sondern auch die Kanten behandelt werden, was besonders bevorzugt ist. Für den Fachmann ist klar, dass die Behandlung nicht nur durch Absenken in ein Flüssigkeitsbad, sondern auch anders erfolgen kann, solange gewährleistet ist, dass tatsächlich nur eine Seite, gewünschtenfalls auch die Kanten, von dem Ätzmittel benetzt und damit modifiziert wird. Beispielsweise können gemäß einer weiteren Ausführungsform zwei unterschiedlich große Behälter vorgesehen werden, wobei der kleinere Behälter die flüssige Zusammensetzung enthält und von dem größeren Behälter umschlossen wird. Der kleinere Behälter ist randvoll mit der Flüssigkeit befüllt und erhält seine Speisung durch eine Verbindung zum größeren Behälter. Diese Flüssigkeitszufuhr kann z.B. kontinuierlich mittels Pumpe erfolgen und so eingestellt werden, dass stets eine gewisse Menge der Ätzflüssigkeit in das Außenbecken (der größere Behälter) überläuft, wobei die Flüssigkeit von dort vorzugsweise wieder in das innere Becken (den kleineren Behälter) zurückgepumpt wird. Das Pumpen der flüssigen Zusammensetzung bewirkt, dass sich der Flüssigkeitsstand immer etwas höher als der umlaufende Rand des kleineren Behälters befindet, wobei die Differenz zwischen dem Pegelstand der Flüssigkeit und der Höhe des Behälterrandes u.a. von der Oberflächenspannung des gegebenen Ätzmediums abhängt. Unter Verwendung dieser' Anordnung können die zu behandelnden Scheiben im Rahmen einer Fertigungsstraße leicht horizontal über die Flüssigkeit befördert werden, so dass die Unterseite der Scheiben benetzt wird, ohne dass die Scheiben an den seitlichen Wandungen des kleineren Innenbehälters anstoßen und beschädigt werden können.

Es wird darauf hingewiesen, dass das vorgeschlagene einseitige Benetzen bzw. Behandeln eines Substrats in den vorliegend beschriebenen Ausführungsformen auf unterschiedliche Art und Weise erzielt bzw. unterstützt werden kann, wobei grundsätzlich zwischen aktiver (direkter) und passiver (indirekter) Benetzung unterschieden wird.

Unter aktiver bzw. direkter Benetzung wird verstanden, dass die gewünschte einseitige Behandlung des Substrats direkt durch die Führung desselben durch die Behandlungsflüssigkeit sichergestellt wird. Dies erfordert, dass sich das Niveau der zu behandelnden Substratunterseite zumindest kurzzeitig unterhalb des maximalen Pegelstandes der Behandlungsflüssigkeit befindet. Im Rahmen der aktiven Benetzung kann z.B. das Substrat in die Flüssigkeit abgesenkt oder der Pegelstand der Flüssigkeit im Becken vollständig oder partiell angehoben werden, wobei auch eine Kombination aus Absenken des Substrats und Anheben des Pegelstandes der Flüssigkeit umfasst ist.

Zum Beispiel kann die Oberfläche des Bades an der Stelle, an welcher die Substrate in das Bad eingeführt werden, durch einen entsprechend angeordneten und gerichteten Flüssigkeitszulauf unterhalb der Oberfläche lokal angehoben werden. Ferner kann die Badoberfläche durch Einblasen von Gasblasen unterhalb des Substrates, z. B. mit Druckluft, partiell angehoben werden, wodurch die Benetzung der Substratunterseite ebenfalls sichergestellt werden kann.

Demgegenüber wird unter passiver bzw. indirekter Benetzung erfindungsgemäß verstanden, das sich die zu behandelnde Unterseite des Substrats über die gesamte Behandlungsdauer oberhalb des Pegelstandes der Flüssigkeit befindet, so dass eine Benetzung lediglich indirekt durch Bauteile oder Komponenten des systems erfolgt, die ihrerseits mit der Flüssigkeit in Kontakt stehen und die Benetzung der Substratunterseiten vermitteln. In diesem Zusammenhang wird darauf hingewiesen, dass die zu behandelnde Substratseite durch Kontakt mit dem vermittelnden Bauteil entweder vollständig (vollflächig) oder aber auch nur partiell benetzt zu werden braucht, denn durch die hygroskopischen Eigenschaften der Oberfläche von Siliziumscheiben wird sichergestellt, dass auch eine teilweise Benetzung der Unterseite durch ein Bauteil innerhalb kürzester Zeit zu einer vollflächigen Benetzung führt.

Hinsichtlich der Komponenten und Bauteile, die für die indirekte Benetzung vorgesehen werden können, wird darauf hingewiesen, dass diese entweder Bestandteil der vorliegend dargelegten Transportsysteme oder aber im Flüssigkeitsbad derart angeordnet sind, dass sie zumindest teilweise aus der Flüssigkeit herausragen oder herausgefahren werden können. Demnach kommen erfindungsgemäß gleichermaßen feststehende, rotierende oder in der Höhe verfahrbare Bauteile in Betracht. Vorzugsweise wird durch die Oberflächeneigenschaft und/oder durch die Formgebung (z. B. durch Ausnutzung eines Kapillareffekts) des Bauteils sichergestellt, dass dessen für den Kontakt mit der Substratunterseite vorgesehene Bereich benetzt ist und die Benetzung der zu behandelnden Oberfläche bewirkt, ohne dass das Substrat selbst mit dem Flüssigkeitsbad in Berührung kommt. Beispielweise handelt es sich bei dem Bauteil um eine Benetzungswalze, die sich in der Flüssigkeit des Bades dreht und durch die Drehbewegung Ätzflüssigkeit aufnimmt, mit der dann die sich oberhalb des Pegelstandes befindenden Substratunterseiten benetzt werden. Wie bereits ausgeführt, können erfindungsgemäß aber auch anders gestaltete Bauteile wie (in der Höhe verfahrbare) Tische, Stifte oder Stempel eingesetzt werden, da überraschenderweise sogar eine punktförmige Kontaktierung der Substratunterseite ausreicht, um eine vollflächige Benetzung zu gewährleisten.

Die Verwendung eines Transportsystems zur Führung der zu behandelnden Substrate im Rahmen des erfindungsgemäßen Verfahrens ermöglicht grundsätzlich die passive Benetzung. Im Falle der aktiven Benetzung wird das zu behandelnde Substrat durch die Flüssigkeit geführt, während die passive Benetzung durch entsprechend ausgestaltete Komponenten des Transportsystems erfolgt.

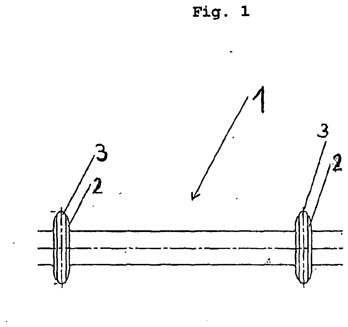

Die erfindungsgemäße Eignung beispielhafter Transportsysteme wird nachfolgend unter ergänzender Bezugnahme auf Figur 1 näher erläutert.

Nach einer Ausführungsform der vorliegenden Erfindung werden die Substrate auf ein Transportsystem, wie z.B. ein Rollentransportsystem gelegt. Hierbei werden die Substrate mit Hilfe von mehreren hintereinander angeordneten und waagerecht ausgerichteten Transportrollen (1) transportiert. Im Sinne der oben definierten aktiven Benetzung sind die einzelnen Transportrollen in einem Flüssigkeitsbad vorzugsweise derart angeordnet, dass sich die jeweils obere Kante der Rollen ungefähr auf der Höhe der Badoberfläche, d.h. des oberen Flüssigkeitsrandes der Flüssigkeit, befindet, so dass die Unterseite des Substrats durch direkten Kontakt mit der Badoberfläche benetzt wird. Hierbei kann sich ein Meniskus an den Substratkanten bilden. Ein Zusammenspiel aus Schwerkraft und Oberflächenspannung zieht dann das Substrat nach unten und sorgt dafür, dass es in Kontakt mit den Rollen bleibt, ohne aufzuschwimmen. Dadurch ist ein kontrollierter und definierter Transport der Substrate mit dem Rollentransportsystem möglich. Wesentlich ist hierbei, dass die Höhe des Flüssigkeitsbades im Bezug auf das Transportsystem so genau eingestellt werden kann, dass eine Benetzung der Unterseite und eventuell der Kanten der Substrate möglich ist, ohne dass die jeweiligen Oberseiten benetzt werden. Auch muss die Gestaltung des Transportsystems den Kontakt zwischen den Substraten und der Flüssigkeit im Flüssigkeitsbad ermöglichen.

Nach einer besonders bevorzugten Ausführungsform befinden sich auf der Transportrolle (1) mindestens zwei Auflageelemente (3), die vorteilhafterweise auf der Transportrolle im Bereich zweier Nuten (2) angeordnet sein können. Der Abstand zwischen den Auflageelementen wird durch die Breite der zu behandelnden Substrate vorgegeben. Im Rahmen der aktiven Benetzung beziehen sich die obigen Ausführungen zur Positionierung der Transportrollen bei dieser Ausführungsform auf die Auflageelemente.

Im Sinne der oben definierten passiven Benetzung bewirken die Transportrollen s.elber oder aber die Auflageelemente die vollständige oder partielle Benetzung der Substratunterseiten.

Die Transportrolle ist vorzugsweise mindestens zweiteilig aufgebaut und besteht aus einem Achselement und mindestens einem das Achselement umgebenden Spurelement. Das Achselement kann entweder die Funktion eines reinen Stabilisators oder die einer stabilisierenden Lagerung besitzen. Bevorzugt handelt es sich um eine Lagerachse. Das Material der Achse, die weder mit dem Transportgut, noch mit einer unter Umständen aggressiven chemischen Umgebung in Berührung kommt, kann rein nach mechanischen und thermischen Gesichtspunkten gewählt werden. Erfindungsgemäß ist es biegesteif. Dem Spurelement hingegen sind durch die stabilisierende Lagerachse gewisse thermisch Toleranzen erlaubt. Für das Material ist entscheidend, dass es weder mit dem Stückgut, noch mit dem Umgebungsmedium reagiert. Die biegesteife Lagerachse gewährleistet, dass das Transportgut in der zur Transportrichtung senkrechten Richtung in einer festgewählten Geraden gehalten wird. Dadurch erfolgt ein Gleichlauf der Transportrolle entlang ihrer gesamten Länge, was insbesondere bei breiteren Transportrollen mit mehreren Transportspuren und für flaches, bruchempfindliches Transportgut von Bedeutung ist.

In einer bevorzugten Ausführung ist das Achselement aus einem Kohlefaserverbundstoff gefertigt. Kohlefaserverbundstoffe besitzen eine hohe thermische und mechanische Stabilität und eignen sich deshalb besonders gut als Lagerachse im Einsatz bei wechselnden Temperaturen.

In einer bevorzugten Ausführungsform ist die Lagerachse geaenüber dem Medium, durch welches das Transportgut behandelt wird, beispielsweise mittels Dichtringen, abgekapselt. Das Medium, bei dem es sich erfindungsgemäß um ein nasschemisches Bad handelt, kommt dann lediglich mit dem Äußeren der Spurelemente in Berührung und das flüssige Medium kann nicht in das Innere der Spurelemente, an die Lagerachse oder an eventuell vorhandene Fixierelemente zwischen Lagerachse und Spurelementen gelangen. Die Dichtung kann flüssigkeitsfest oder sogar in gewissem Grade gasfest ausgeführt sein, sodass auch keine schädlichen Dämpfe in das Innere der Spurelemente gelangen.

Die Spurelemente sind in beliebiger Länge zusammenfügbar, eine Transportrolle kann beispielsweise aus einer Achse mit beliebig vielen Spurelementen bestehen. Ein Transportrollenhersteller oder -vertreiber kann auf die Anforderungen eines Kunden sehr flexibel eingehen, ohne eine komplizierte Lagerhaltung zu betreiben. Das Spurelement ist, da es für Transportrollen jeglicher Länge einsetzbar ist, ein Massenartikel, was den Herstellungspreis senkt.

Die Spurelemente können zum Beispiel zusammensteckbar, aneinander schraubbar, mit einem Clip verbindbar oder miteinander verschweißbar sein.

Die eigentliche Auflage des zu behandelnden Substrats findet in einer bevorzugten Ausführungsform an Auflageelementen (3) mit für das Werkstück passenden Haftreibungseigenschaften statt, wobei die Auflageelemente wie erwähnt neben dem Transport auch der passiven Benetzung dienen können. Diese Elemente sollten ebenfalls thermisch und chemisch stabil sein. Für die Fertigung von Solarzellen hat sich die Verwendung von O-Ringen aus Fluorkautschuk bewährt. Da der Durchmesser, den die Auflageelemente aufspannen, größer ist als der Rest des Spurelements, erfährt das Transportgut nur eine punktförmige Berührung und ggf. Benetzung. Dies trägt im Gegensatz zu einer Linienberührung zur Schonung des Transportguts bei und gewährleistet gleichzeitig guten Kontakt mit dem umgebenden Medium.

In einer weiteren vorteilhaften Ausführung ist das Spurelement aus Kunststoff gefertigt. Kunststoff lässt sich bekanntermaßen leicht bearbeiten und bietet eine breite Palette von unterschiedlichen Eigenschaften, die je nach Verwendung und Einsatzort der Transportrolle ausgewählt werden. Beispielsweise hat sich die Verwendung von Polyethylen, Polyfluoralkoxyd oder Polyvinylidenfluorid bewährt. Diese Materialien sind bis über 80 Grad Celsius temperaturbeständig, schweissbar, haben eine gewisse chemische Beständigkeit, verursachen keine Metallkontamination und haben einen geringen Abrieb.

Eine vorteilhafte Weiterbildung der Erfindung besteht darin, dass Spurelemente antreibbar sind. Das heisst, es ist möglich, dass der Antrieb nicht auf die Lagerachse ausgeübt und von dieser an die Spurelemente weitergeleitet wird, sondern dass er direkt auf die Spurelemente wirkt. Transportrollen mit derartigen Spurelementen lassen sich zu besonders gleichlaufenden Transportsystemen zusammenfügen. Auf das Transportgut wird eine optimale Traktion übertragen.

In einer Ausführung besitzt von einer zusammengefügten Reihe von Spurelementen ein erstes Randelement Mittel zur Übertragung der Antriebskraft und ein zweites Randspurelement Mittel zur drehbaren Lagerung. Der Antrieb kann über ein auf einer Antriebswelle angebrachtes Koppelelement, das mit dem ersten Randspurelement verbindbar ist, auf die Transportrolle übertragen werden. Das Koppelelement besitzt außerdem eine Aufnahmemöglichkeit für die Lagerachse. Soll eine Transportrolle aus einer Transportposition entfernt werden, so ist zunächst das zweite Randspurelement aus der Lagerung zu lösen, die gesamte Transportrolle um das Koppelelement zu schwenken und anschließend die Transportrolle aus dem Koppelelement zu entfernen.

Die Mittel zur drehbaren Lagerung können aus einer oberen und unteren Halbschale bestehen, wobei die untere Halbschale an der Wand des Transportsystems fixiert ist und zur Auflage der Transportrolle dient, und die zweite obere Halbschale lösbar zur Arretierung befestigt wird.

Vorteilhafterweise entspricht die Breite des Spurelementes mindestens der Breite des zu transportierenden Werkstücks, sodass ein Werkstück breitseitig nur auf einem Spurelement liegt. Vorzugsweise nimmt jedes Spurelement nur ein Werkstück auf, das heißt, die Breiten von Spurelement und Transportgut sind nahezu gleich.

In einer vorteilhaften Ausführung der Transportrolle ist auf der Lagerachse ein Fixierring angebracht, wobei der Innendurchmesser eines Spurelementes mindestens an einer Stelle kleiner ist als der Durchmesser des Fixierrings. Der Fixierring verhindert somit, dass ein Spurelement auf der Lagerachse größere Bewegungen ausführen kann. Dies spielt vor allem bei Temperaturänderungen eine Rolle, wenn sich das Material von Lagerachse und Spurelementen unterschiedlich ausdehnt und dadurch eine Bewegung relativ zueinander verursacht werden könnte.

Der Fixierring ist bevorzugt aus Metall gefertigt, da sich Metall gut an die Achse biegen und dort festklemmen lässt.

Für den Einsatz bei unterschiedlichen Temperaturen sollen geringe Längenänderungen nicht die Stabilität der gesamten Transportrolle beeinträchtigen. Deshalb sind die Spurelemente in einer weiteren vorteilhaften Ausführung der Erfindung mit einer Kompensationsfalte versehen, an der thermische Ausdehnungen ausgeglichen werden. Die Kompensationsfalte besteht in der Regel aus einer innenseitig hohlen Auswölbung im Material des Spurelements, welche die temperaturbedingte Materialausdehnung durch Streckung in Längsrichtung auffängt. Wenn die Kompensationsfalte sich nicht zwischen den Auflagepunkten des Transportguts befindet, so bleibt die Auflagestabilität auch bei temperaturbedingten Längenänderungen stabil. Wenn außerdem die Spurelemente jeweils an der Lagerachse fixiert sind, bleibt auch die Geradlinigkeit der Spur erhalten.

Die gleichmäßige Führung des Transportguts wird besonders gut gewährleistet, wenn erfindungsgemäße Transportrollen zu einem Transportsystem zusammengefügt werden.

In einer bevorzugten Weiterbildung des Transportsystems wird jede Transportrolle angetrieben. Dabei erfährt jede Transportrolle die gleiche Kraftübertragung und wird somit auch gleich belastet.

Da die Transportführung durch das erfindungsgemäß vorgeschlagene Transportsystem einen hohen Durchsatz ermöglicht, gleichzeitig sehr schonend für das Transportgut ist, besteht eine besondere Eignung für den Einsatz im Rahmen des erfindungsgemäßen Verfahrens.

Eine weitere Transportmöglichkeit in einem Transportsystem bildet ein laufender Balken. Bei diesem System werden zwei oder mehrere Balken verwendet, welche die Substrate abwechselnd nach vorne transportieren. Während ein erster Balken sich nach vorne bewegt, bewegt sich ein zweiter Balken nach hinten. Hierbei liegt der zweite Balken tiefer im Flüssigkeitsbad und hat keinen unmittelbaren Kontakt mit dem Substrat. Ist der erste, bzw. obere Balken am Ende seiner möglichen Transporthubs angelangt und der zweite, bzw. untere an dessen Anfang, wird der untere Balken angehoben, so dass die Substrate mit beiden Balken in Kontakt kommen. Der obere Balken wird dann abgesenkt und kann somit wieder zum Anfang des Flüssigkeitsbades fahren, während der untere Balken eine Vorwärtsbewegung ausführt.

Bei gebräuchlichen Ausführungen eines derartigen Balkentransportsystems sind die Balken auf drehenden Wellen mit einem Excenter gelagert, d. h. sie bewegen sich fortwährend hoch und runter. Um jedoch eine einseitige Behandlung von Substraten zu gewährleisten, müssen die Substrate im Sinne der aktiven Benetzung immer auf der gleichen Höhe bleiben. Entsprechende Modifikationen eines gebräuchlichen Balkentransportsystems und dessen Verwendung im Sinne der oben definierten passiven Benetzung sind jedoch einem Fachmann in Kenntnis der vorliegenden Beschreibung unmittelbar ersichtlich.

Somit lässt sich das erfindungsgemäße Verfahren besonders vorteilhaft in einer Durchlaufanlage durchführen, denn im Rahmen einer derartigen "Inline"-Produktion entfällt jeglicher zusätzlicher Handlingschritt der Scheiben. Ferner kann die erfindungsgemäße Rückseite/Kantenisolierung zusammen mit dem Oxidätzen in der gleichen Anlage stattfinden, wodurch die Prozesskette einfacher und kostengünstiger wird. Weiterhin können unter Anwendung des erfindungsgemäßen Verfahrens auch solche Zellenkonzepte realisiert werden, bei denen die Rückseite der Zelle kein vollflächiges "Aluminium Back Surface Field" (AlBSF) aufweist. Da bei dem erfindungsgemäßen Verfahren die n-dotierte Schicht auf der Rückseite der Zelle komplett entfernt wird, ist es nicht mehr zwingend notwendig, diese Dotierung durch die Bildung eines AlBSF zur Bildung einer p-dotierten Zone zu kompensieren. Dies läßt mehr Möglichkeiten zur Gestaltung der Rückseite der Zelle offen und vereinfacht die Realisierung von Zellkonzepten ohne AlBSF.

Je nach Verfahren (kontinuierlich oder diskontinuierlich) kann es sein, dass die flüssige Zusammensetzung Zusätze z.B. zur Vermeidung oder Verkleinerung von Gasblasen benötigt, wobei derartige Zusatzstoffe vom Fachmann unter Berücksichtigung der konkreten Erfordernisse leicht ausgewählt werden können. Bei der Auswahl geeigneter Zusätze, insbesondere im Durchlaufverfahren, ist zu beachten, dass die Wafer durch eine eventuelle Gasblasenbildung keinen zu großen Auftrieb bekommen, der den effektiven Transport beeinträchtigen könnte, da die Wafer dadurch den Kontakt zu einem entsprechenden Transportmittel verlieren können. Folglich wird gemäß einer bevorzugten Ausführungsform vorgeschlagen, dass die Ätzlösung mindestens einen Zusatzstoff enthält, der in der Lage ist, die bei der chemischen Reaktion entstehenden Gase weitgehend zu binden, so dass die Bildung von Gasblasen auf der Unterseite der Scheiben weitgehend unterbunden wird.

Es wird darauf hingewiesen, dass das erfindungsgemäße Verfahren zur elektrischen Isolation der beiden Seiten von Wafern oder Solarzellen angewendet werden kann.

## Patentansprüche

1. Verfahren zur elektrischen Isolation beider Seiten von Siliziumscheiben durch deren einseitige nasschemische Behandlung unter Verwendung eines Flüssigkeitsbades,
- bei dem die Scheiben auf in der Flüssigkeit angeordneten Transportrollen aufliegen und im Rahmen einer Fertigungsstraße horizontal über die im Bad befindliche Flüssigkeit befördert werden, wobei das Niveau der von der Unterseite kontaktierten Flüssigkeit über die gesamte Behandlungsdauer oberhalb des Pegelstandes der nicht von der Unterseite kontaktierten Badoberfläche gehalten wird, und
- bei welchem eine Benetzung der Unterseite lediglich indirekt durch die Transportrollen erfolgt.

2. Verfahren nach einem der vorhergehenden Ansprüche,
**dadurch gekennzeichnet,**
**dass** als Flüssigkeitsbad ein Becken verwendet wird, dessen umlaufender Rand niedriger als der Pegelstand der Flüssigkeit ist.

3. Verfahren nach einem der vorhergehenden Ansprüche,
**dadurch gekennzeichnet,**
**dass** die Behandlung ein Ätzen ist.

4. Verfahren nach Anspruch 3,
**dadurch gekennzeichnet,**
**dass** das Ätzen in einer flüssigen Zusammensetzung erfolgt, die KOH, HF, HNO₃, HF mit O₃, und/oder HF mit Oxidationsmittel enthält.

5. Verfahren nach Anspruch 4,
**dadurch gekennzeichnet,**
**dass** das Oxidationsmittel eine oxidierende Säure ist.

6. Verfahren nach Anspruch 4 oder 5,
**dadurch gekennzeichnet,**
**dass** die flüssige Zusammensetzung mindestens einen Zusatz zur Bindung der beim Ätzen entstehenden Gase enthält.

## Claims

1. Method for the electrical isolation of both sides of silicon wafers by the wet-chemical treatment on one side thereof by using a liquid bath,
- for which the wafers rest on transport rollers placed in the liquid and are conveyed, in the course of a production line, horizontally above the liquid located in the bath, wherein the level of the liquid in contact with the lower side is maintained above the level of the bath surface that is not in contact with the lower side during the overall duration of the treatment and
- for which a wetting of the lower side takes place only indirectly through the transport rollers.

2. Method according to one of the preceding claims, **characterized in that** a basin, the circumferential edge of which is lower than the level of the liquid, is used as a liquid bath.

3. Method according to one of the preceding claims, **characterized in that** the treatment is an etching.

4. Method according to claim 3, **characterized in that** the etching takes place in a liquid composition that contains KOH, HF, HNO₃, HF with O₃, and/or HF with an oxidizing agent.

5. Method according to claim 4, **characterized in that** the oxidizing agent is an oxidizing acid.

6. Method according to claim 4 or 5, **characterized in that** the liquid composition contains at least one additive for the binding of the gases resulting from etching.

## Revendications

1. Procédé pour l'isolation électrique des deux côtés de plaquettes de silicium par leur traitement chimique par voie humide sur un côté en utilisant un bain de liquide
- pour lequel les plaquettes reposent sur des galets de transport placés dans le liquide et sont transportées, dans le cadre d'une chaîne de fabrication, horizontalement au-dessus du liquide qui se trouve dans le bain, le niveau du liquide qui est en contact avec le côté inférieur étant maintenu au-dessus du niveau de la surface du bain qui n'est pas en contact avec le côté inférieur pendant toute la durée du traitement et
- pour lequel une humidification du côté inférieur a lieu uniquement de manière indirecte par les galets de transport.

2. Procédé selon l'une des revendications précédentes, **caractérisé en ce qu'**un bassin dont le bord périphérique est plus bas que le niveau du liquide est utilisé comme bain de liquide.

3. Procédé selon l'une des revendications précédentes, **caractérisé en ce que** le traitement est une gravure.

4. Procédé selon la revendication 3, **caractérisé en ce que** la gravure se fait dans une composition liquide qui comprend du KOH, du HF, du HNO₃, du HF avec de l'O₃, et/ou du HF avec un moyen d'oxydation.

5. Procédé selon la revendication 4, **caractérisé en ce que** le moyen d'oxydation est un acide oxydant.

6. Procédé selon la revendication 4 ou 5, **caractérisé en ce que** la composition liquide contient au moins un additif pour la liaison des gaz qui se dégagent lors de la gravure.
